# EUROPEAN PATENT APPLICATION

(11) **EP 4 793 227 A1**
(43) Date of publication of application: **19.08.2026**
(21) Application number: 25158196.3
(22) Date of filing: 17.02.2025
(51) Int. Cl.: B81C 1/00

(54) **ASIC CAPPED MEMS DEVICE**

(71) Applicant: Murata Manufacturing Co., Ltd., Nagaokakyo-shi, Kyoto 617-8555 (JP)
(72) Inventor: RYTKÖNEN, Ville-Pekka, 01820 Klaukkala (FI); BLOMQVIST, Anssi, 00980 Helsinki (FI); KILPINEN, Petteri, 02620 Espoo (FI); IIHOLA, Antti, 00950 Helsinki (FI)
(74) Representative: Boco IP Oy Ab

(57) **Abstract**

The disclosure relates to microelectromechanical (MEMS) devices. The MEMS device comprises an ASIC layer, a MEMS device layer and a cap layer and bonding layers therebetween form an enclosure for movable MEMS elements. The MEMS device layer and the cap layer comprise at least one ASIC signal through-silicon-via that electrically connects signals of an ASIC active circuitry the respective metal pad on the outer face of the cap layer.

## Description

### FIELD OF THE DISCLOSURE

The present disclosure relates to microelectromechanical (MEMS) devices, and particularly to a MEMS device in which electrical signals from an ASIC active area are coupled through a MEMS device layer and a cap layer to and/or from the outside of the MEMS device. The present disclosure further relates to a method of manufacturing a MEMS device.

### BACKGROUND OF THE DISCLOSURE

One traditional type of MEMS devices is to one in which signals between a standard CMOS ASIC wafer/chip and a MEMS wafer/chip are wire bonded.

A problem of this type of interconnections is that bonding wires may be mechanically fragile and subject to external disturbance. Especially, some signals produced by the MEMS device that need to be coupled to the ASIC for processing may be weak, and coupling these over bonding wires may rise problems in accuracy of the MEMS device. In particular, capacitive sensing is sensitive to stray capacitances and even a slight displacement in bonding wires or change in permittivity of the medium between wires can lead to significant errors in measurement.

Other known MEMS device basic structure is based on an idea of bonding a MEMS wafer on top of a CMOS ASIC wafer and providing interconnections between the two wafers under the MEMS wafer. Document US 2016/0152466 A1 discloses a MEMS sensor device in which signals from micromechanical functional layers are on top of an ASIC wafer, and signals are coupled by vias through an ASIC substrate.

A problem with such a MEMS device is that often an ASIC circuit requires greater lateral area than MEMS active elements. If any MEMS signals are brought outside the MEMS device through vias the ASIC substrate, this necessarily increases area of the ASIC circuit, which adds total cost of the MEMS device.

### BRIEF DESCRIPTION OF THE DISCLOSURE

An object of the present disclosure is to provide a MEMS device so as to solve the above problem.

The object of the disclosure is achieved by a MEMS device which are characterized by what is stated in the independent claims. Some embodiments of the disclosure are disclosed in the dependent claims.

The disclosure is based on the idea of capping the MEMS device layer with an ASIC layer, using a passive cap layer as bottom layer of the MEMS device. Digital signals, ground and operating voltage(s) are carried between the ASIC layer and outside of the MEMS device through ASIC signal through-silicon-vias, in short AS-TSVs, extending through the MEMS device layer and the cap layer. The passive cap layer is used as the bottom layer of the MEMS device. During manufacturing, MEMS device layer, ASIC layer and cap layer are preferably handled in wafer form. In this context, the term wafer refers to a wafer comprising respective MEMS, ASIC or cap layer elements for a plurality of MEMS devices. Term layer refers both to a layer of a wafer and to a layer of a MEMS device after dicing.

According to a first aspect, a microelectromechanical (MEMS) device is provided. The MEMS device comprises an ASIC layer comprising: i) an ASIC metal stack towards a first face of the ASIC layer, and ii) a substrate towards a second face of the ASIC layer. The first face of the ASIC layer comprises a plurality of coupling elements on the first face of the ASIC layer. The plurality of coupling elements is electrically coupled to the ASIC metal stack, wherein face of the substrate layer that faces the ASIC metal stack comprises ASIC active circuitry. The ASIC metal stack is configured to convey signals between the ASIC active circuitry and the plurality of coupling elements.

The MEMS device comprises a MEMS device layer comprising functional elements of the MEMS device. The MEMS device layer has a first face and a second face. Parts of the second face of the MEMS device layer are bonded on parts of the first face of the ASIC layer.

The MEMS device comprises a cap layer having a first face and a second face. Parts of the second face of the cap layer are bonded on parts of the first face of the MEMS device layer. The first face of the cap layer is provided with a plurality of metal pads. The cap layer, the ASIC layer and parts of the MEMS device layer and optional bonding material between these layers form an enclosure for at least all movable functional elements of the MEMS device layer.

Mutually electrically connected parts of the MEMS device layer and the cap layer form at least one ASIC signal through-silicon-via, AS-TSV. The AS-TSV is configured to electrically connect digital signal, ground or operating voltage of the ASIC active circuitry via some of the electrical contacts provided on the first face of the ASIC metal stack to the respective one of the metal pads on the first face of the cap layer.

According to some embodiments, the parts of the second face of the MEMS device layer are CMOS-compatible low temperature wafer bonded on the first face of the ASIC layer. The CMOS-compatible low temperature wafer bonding is selected among glass frit bonding, adhesive bonding, anodic bonding, eutectic metal bonding, metal to metal bonding and direct bonding.

According to some embodiments, the parts of the second face of the cap layer are CMOS-compatible low temperature wafer bonded, or CMOS non-compatible high temperature wafer bonded on parts of the first face of the MEMS device layer. The CMOS-compatible low temperature wafer bonding and the CMOS non-compatible high temperature wafer bonded are selected among glass frit bonding, adhesive bonding, anodic bonding, eutectic metal bonding, metal to metal bonding or direct bonding.

According to some embodiments, the parts of the second face of the cap layer are bonded on parts of the first face of the MEMS device layer by a dielectric layer. Metal pads are electrically coupled to parts of the MEMS device layer by means of dielectric-shielded vias extending through the dielectric layer.

According to some embodiments, the MEMS device layer comprises at least one movable element configured to be moveable in out-of-plane direction between the first face of the ASIC layer and the second face of the cap layer. The MEMS device comprises second electrodes arranged on the first face of the ASIC layer and/or first electrodes arranged the second face of the cap layer for capacitively detecting out-of-plane movement of the at least one movable element.

According to some embodiments, at least one first electrode and/or at least one second electrode is provided with a dielectric bump at the face of the respective at least one first electrode and/or the respective at least one second electrode facing the moving element.

According to some embodiments, at least one via portion of the at least one AS-TSV is disposed on outer circumference of the MEMS device layer, thus forming part of outer walls of the enclosure.

According to some embodiments, the at least one AS-TSV is coaxially shielded in the MEMS device layer by a through hole or by a dielectric material surrounding respective via portion of the MEMS device layer.

According to some embodiments, the cap layer comprises sodium borosilicate glass and doped monocrystalline or polycrystalline silicon.

According to some embodiments, the cap layer is a monocrystalline silicon layer comprising a plurality of dielectric-shielded vias.

According so tome embodiments, the dielectric-shielded via (126) comprises a doped monocrystalline or polycrystalline rod in a silicon dioxide tube.

According to some embodiments, in addition to a metal bonding layer or a eutectic bonding layer between parts of the MEMS device layer and the ASIC layer, dielectric patterns reside between parts of the MEMS device layer and the ASIC layer. The dielectric patterns are configured to provide further mechanical support and/or to facilitate maintaining desired distance between the first face of the ASIC layer and parts of the second face of the MEMS device layer.

According to some embodiments, the plurality of metal pads on the first face of the cap layer are provided with solder bumps for enabling soldering of the MEMS device on a printed circuit board.

According to some embodiments the MEMS device is an accelerometer, a gyroscope or a combination thereof.

An advantage of the MEMS device of the disclosure is that it removes need for separate component package for the MEMS device, and assembly of the MEMS device to the package. It also streamlines manufacturing process, since all steps can be performed in wafer level, from manufacturing to testing and/or calibrating of MEMS devices. Electrical connection paths between MEMS device layer and the ASIC layer are minimized, and electrical connection paths between the ASIC layer to underlying PCB are also kept short. Stray capacitances of electrical connections can be kept low and stable, which is particularly important for MEMS to ASIC AC connections and ground connections and between terminals. Shorter and more stable electrical connections facilitate better and stronger signals and improved error compensation, which enables reducing size of the MEMS device. MEMS device size can be reduced in comparison to MEMS device designs that use internal bonding wires.

The structure enables two-side out-of-plane detection, and gap depths that enable movement of movable elements in the MEMS device layer can be set separately. The structure also provides greater signal per used MEMS sensor area as well as greater flexibility of MEMS detection structure design, since some MEMS detection structures need a deeper gap and some MEMS detection structures need only more shallow gap.

### BRIEF DESCRIPTION OF THE DRAWINGS

In the following the disclosure will be described in greater detail by means of preferred embodiments with reference to the accompanying drawings, in which:
Figure 1 illustrates a MEMS device according to some embodiments;
Figure 2 illustrates MEMS devices according to some embodiments;
Figure 3 illustrates MEMS devices according to some embodiments, before separating them;
Figure 4 illustrates a MEMS device layer;
Figure 5A illustrates a MEMS device layer capped with a cap layer;
Figure 5B illustrates a MEMS device layer capped with a thinned cap layer;
Figure 6 illustrates removal of substrate layer and releasing of a buried dielectric;
Figure 7 illustrates patterning of the buried dielectric to form a dielectric mask;
Figure 8 illustrates deposition of bonding material using the dielectric mask;
Figure 9 illustrates removal of the dielectric mask;
Figure 10 illustrates removal of a photoresist;
Figure 11A illustrates bonding of an ASIC layer;
Figure 11B illustrates bonding or thinning of an ASIC layer;
Figure 12 illustrates a MEMS device according to some embodiments;
Figure 13 illustrates a MEMS device according to some embodiments.

The figures are for illustrative purposes only and are not shown in scale. Some elements may have been exaggerated to improve visibility thereof.

### DETAILED DESCRIPTION OF THE DISCLOSURE

The disclosure relates to microelectromechanical systems (MEMS) devices and to methods of manufacturing of MEMS devices.

In the following drawings, features of the invented MEMS device are illustrated with help of cross-sections of parts of wafers and/or layers forming the MEMS device or as cross-sections of the MEMS device itself. It is preferable to perform manufacturing steps in wafer form, so that a plurality of MEMS devices is manufactured at the same time, and the readily manufactured and preferably also tested MEMS devices are separated from each other only at the very end of the manufacturing process. Handling of wafers is easier than handling of individual devices, which gives significant benefits through reduced complexity and thus cost savings.

In this context, out-of-plane movement refers to up or down in the figures. The term rises from the fact that the MEMS device layer determines a plane, in which all movable parts of the MEMS device layer are when in rest, in other words when not excited into movement by driving nor by external forces. The exemplary illustrative drawings show cross-sections of an imaginary device, not showing many functional elements of MEMS device layer, such as springs, arms, bars and so on. Only functional elements needed to explain features of the invention are depicted.

Preferably, ASIC, MEMS and cap wafers used in the manufacturing process are at least approximately of the same size, so that they can be conveniently and accurately stacked and bonded with each other. Typical silicon-based wafers are circular, carrying desired parts and/or elements and/or functions for thousands of devices.

As known in the art, MEMS wafers, such as monocrystalline silicon wafers used for manufacturing functional elements of MEMS devices are doped so that silicon can be considered electrically conductive. On the other hand, application-specific integrated circuit (ASIC) wafers are based on pure monocrystalline or polycrystalline silicon structure, which is a semiconductor, and ASIC active circuitry is implemented by appropriately doping the silicon wafer to form active electrical circuitries, routings etc.

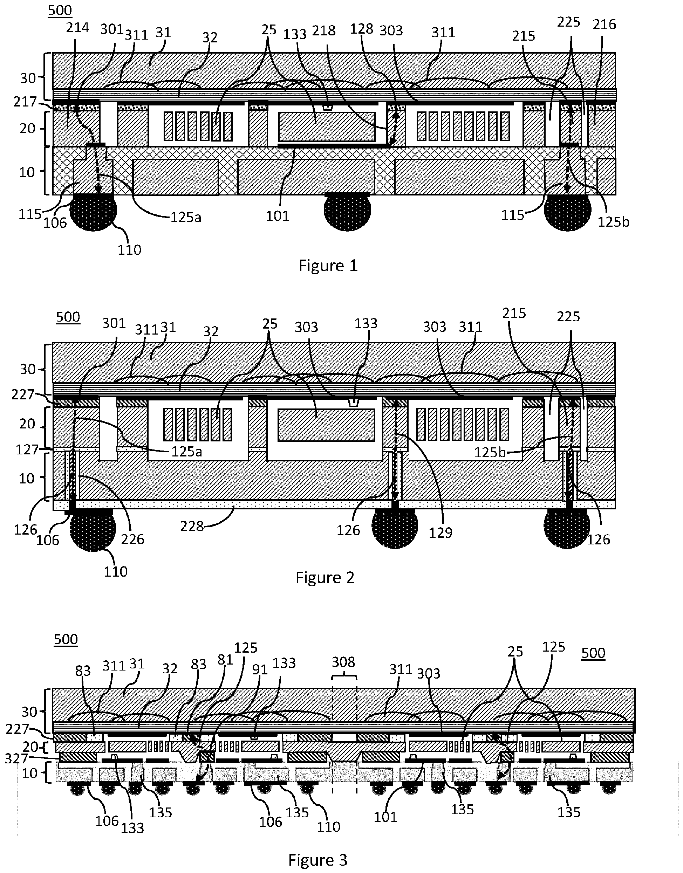

Figure 1 illustrates a cross-section of a microelectromechanical (MEMS) device 500 according to a first embodiment.

In the following description, reference will be made to an inertial MEMS sensor and to the problems for the manufacturing thereof. However, the present disclosure generally applies to other types of MEMS devices. For example, the MEMS device may comprise one or more of the following structures, single or combined with each other: accelerometer, gyroscope, geophone, inclinometer and resonator. Furthermore, the MEMS device may be a MEMS actuator.

The MEMS device may be a gyroscope, or the MEMS device may be an accelerometer. The MEMS device may be both a gyroscope and an accelerometer. According to some embodiments, the same moveable mass element may be used as both the acceleration-sensitive element in the MEMS device, and as an element whose oscillation is altered by the Coriolis force when the device undergoes angular rotation to implement a gyroscope. According to some embodiments, different moveable elements are used for sensing acceleration and angular rotation.

The MEMS device comprises an ASIC layer 30, comprising an ASIC metal stack 32 and a substrate 31. The ASIC metal stack 32 refers to at least one layer of patterned metal structures comprising at least wiring for ASIC signals, but typically also passive electrical components such as resistors and capacitors. In this context, a first face of the ASIC layer 30 refers to the exposed face of the ASIC layer 30 on the side of the ASIC metal stack 32. A second face of the ASIC layer 30 refers to the exposed face of the ASIC layer 30 which is on the side of the substrate 31. The ASIC metal stack 32 is electrically coupled to ASIC active circuitry 311, which is configured to perform signal processing. The ASIC active circuitry 311 is at the face of the substrate 31 that resides towards the ASIC metal stack 32. Active ASIC circuitry 311 has been implemented on the substrate 31, typically made of plain, undoped crystalline silicon.

On the first face of the ASIC layer 30, there are a plurality of metallic patterns 301, 303, which may be electrically coupled to the ASIC active circuitry 311 via the ASIC metal stack 32. Metallic patterns comprise coupling elements 301 configured to convey signals to and/or from the ASIC active circuitry 311 via the wirings and optional resistors and/or capacitors implemented in the ASIC metal stack 32. Metallic patterns on the first face of the ASIC layer 30 may also comprise second electrodes 303. For example, in this embodiment, second electrodes 303 may be capacitive electrodes configured to produce a signal that reflects position of a movable element 25 in a MEMS device layer 20, when the movable element 25 moves in out-of-plane direction, in other words towards or away from the second electrode 303, up or down in the Figure 1.

The MEMS device comprises the MEMS device layer 20. The MEMS device layer 20 comprises functional elements of the MEMS device 500. A first face of the MEMS device layer 20 faces a cap layer 10, and a second face of the MEMS device layer 20 faces the ASIC layer 30. Parts of the second face of the MEMS device layer 20 are bonded on part of the metallic patterns 301, 303 on the first face of the ASIC layer 30. In this example, bonding between the ASIC layer 30, more precisely the metallic patterns 301, 303 of the ASIC layer 30, and parts of the MEMS device layer 20 is a so called eutectic bonding 217, which is effected by an alloy of metal and germanium, for example an alloy of aluminium (Al) and germanium (Ge), or an alloy of Copper (Cu) and germanium (Ge) or an alloy of silver (Au) and germanium (Ge) which are known in the art to provide an electrically conductive bonding. One benefit of using Ge in bonding is that it can be patterned using similar processes as the silicon-based MEMS device layer.

The MEMS device 500 comprises a cap layer 10. A first face of the cap layer 10 is on the outside the MEMS device 500. A second face of the cap layer 10 faces the MEMS device layer 20, and parts of the second face of the cap layer 10 are bonded with the first face of the MEMS device layer 20. The first face of the cap layer 10 is provided with a plurality of metal pads 106. At least some of the metal pads 106 are electrically coupled, by means of via patterns 115 to parts of the MEMS device layer 20. This type of cap layer may be manufactured by patterning a doped silicon wafer, and via patterns 115 are considered electrically conductive. The doped silicon wafer can be patterned using similar techniques that are used for manufacturing the MEMS device layer, using for example photoresist and DRIE etching to pattern the doped silicon wafer and thereafter filling trenches thereof with glass or equivalent. For example, sodium borosilicate glass may be used that has beneficially similar thermal expansion characteristics with crystalline silicon. Alternatively, silicon portions of the cap layer 10 may be made of polycrystalline silicon. In the example of Figure 1, metal pads 106 next to the outer circumference of the MEMS device 500 are electrically coupled by via patterns 115 in the cap layer 10 to parts of the MEMS device layer 20, whereas the middle one illustrates a pad that is not electrically connected to any part of the MEMS device layer 20. In this embodiment, the cap layer 10 is anodic bonded to parts of the MEMS device layer 20. As known in the art, anodic bonding refers to bonding method that applies electrostatic force and electric voltage to make the bonding.

The second face of the cap layer 10 is provided by metallic patterns, which may include first electrodes 101. In this example, the first electrode 101 is configured for capacitively detecting position of a movable element 25 in the MEMS device layer 20, when the movable element 25 moves in out-of-plane direction, in other words towards or away from the first electrode 101, up or down in the Figure 1.

In a typical MEMS device 500, movable elements 25 are in an enclosure, which may be hermetically enclosed. In this example, the ASIC layer 30 and the cap layer 10 form "floor" and "ceiling" of the enclosure, and outer circumference of the MEMS device layer 20, together with portions of the eutectic bonding 217, form walls of the enclosure. In some applications, as known in the art of MEMS, the enclosure may have reduced gas pressure, and/or may comprise special gas content.

Figure 1 illustrates three different types of through-silicon-vias, TSV, for enabling coupling of electrical signals. There are two different examples of ASIC signal through-silicon-vias, AS-TSVs, 125 and one MEMS-TSV 128, all illustrated by the double-ended arrows. An AS-TSV 125 refers to a TSV that couples an electrical signal between the ASIC active circuitry 311 and outside of the MEMS device 500. A MEMS-TSV 128 refers to a TSV that couples an electrical signal from within the enclosure to the ASIC active circuitry 311 or from the ASIC active circuitry 311 to the enclosure. The MEMS-TSV 128 may be coupled to an electrode implemented within the MEMS device layer itself, of it may be coupled to the first electrode 101 on the face of the cap layer 10. The MEMS device layer 20 may comprise MEMS-TSVs 128, if needed in the design, but MEMS-TSVs 128 are optional.

A first AS-TSV 125a, on the left, is arranged on the outer circumference of the MEMS device layer 20, thus forming part of the walls of the enclosure. The first AS-TSV extends from the metal pad 106 through the via pattern 115 in the cap layer, the first through-silicon-via 214 arranged in the MEMS device layer 20, the eutectic bonding 217 and the electrical contact 301 on the first face of the ASIC layer 30. Alternatively, metal bonding may be used. The first through-silicon-via 214 on the outer circumference of the MEMS device layer 20 causes the first AS-TSV 125a to be subject to noise from the outside of the MEMS device, but this type of vias may be useful for example for providing ground or operating power to the ASIC active circuitry 311.

A second AS-TSV 125b, on the right, is a coaxially shielded via. The second AS-TSV 125b extends through the same layers as the first AS-TSV 125a. The second AS-TSV 125b is provided with improved noise protection by means of the coaxial shielding, wherein the second through-silicon via 215 in the MEMS device layer 20 is surrounded by a through hole 225 traversing through the entire MEMS device layer 20. The through hole 225 may be filled with the same gas as the MEMS cavity. Various gases may be used in the MEMS cavities, such as air or a suitable noble gas, such as argon (Ar), Helium (He) or Neon (Ne). In some applications, nitrogen (N₂) may also be used. Gas filling of the cavity affects quality factor (Q-factor) of resonators, in other words damping of moving elements within the cavity. Instead of a through hole 225, the AS-TSV may be surrounded with dielectric material, such as silicon dioxide. Furthermore, parts of the MEMS device layer 20 surrounding the through hole 225 may be grounded. The second AS-TSV 125b both provides protection for the signal from/to the ASIC circuit and the outside of the MEMS device, but also effectively protects sensitive signals between the MEMS device layer 20 and/or first or second electrodes 101, 303 and the ASIC active circuitry 311 from unwanted coupling of digital signals carried by one or more second AS-TSVs 125b. The part 216 of the MEMS device layer 20 that forms outer wall of the enclosure and sleeve of the coaxial second AS-TSV 125b can be grounded. Any one of first or second electrodes 101, 303 may be provided with a dielectric bump 133 to prevent direct contact between the electrode and the respective movable element 25.

Stray capacitances are not a problem for buffered digital ASIC signals, ground and operating voltage. For such signals, length of the electrical path through the AS-TSV can be considered short. On the other hand, sensitive and often weak MEMS AC signals have short electrical paths between the MEMS device layer and/or electrodes and the ASIC active circuitry 311.

In a preferred embodiment, the metal pads 106 on the first face of the cap layer 10 are provided with solder bumps 110 that facilitate attachment of the MEMS device 500 on a printed circuit board, PCB, or equivalent.

Implementation of vias 214, 215 in the MEMS device layer 20 is cost-effective, since these can be manufactured by the same process steps that are used for manufacturing movable elements of the MEMS device layer 20. An ASIC used in a MEMS device 500 typically requires greater lateral area than parts of the MEMS device layer 20 that comprise movable elements 25 of the MEMS. According to the invention, the available "free" area of the MEMS device layer 20 is used for AS-TSVs. This brings a significant cost saving in comparison to some prior art in which the ASIC layer includes TSVs, because total area required by the ASIC chip can be reduced, because such prior art structure has no active ASIC active circuitry collocated with a TSV in the ASIC layer.

Figure 2 illustrates a MEMS device 500 according to a second embodiment. The ASIC layer 30, the MEMS device layer 20 and the cap layer 10 have same type of functionalities, but some structural differences from the first embodiment.

The ASIC layer may be exactly the same as in the first embodiment shown in the Figure 1. The ASIC layer 30 may be bonded on the MEMS device layer 20 using metal bonding 227. Alternatively, eutectic bonding may be used, for example by means of Al-Ge alloy, Au-Ge alloy or Cu-Ge alloy.

Instead of pure binary Al-Ge alloy, titanium (Ti) may be included in the final metal bond alloy too. In such ternary alloy case the titanium is typically deposited both under the germanium layer and under the aluminium layer. Optionally a layer of titanium can be sandwiched between the aluminium (Al/Ti/Al) or germanium (Ge/Ti/Ge) layers or even in a multilayered arrangement, i.e. (Ti/Al/Ti/Al) or (Ti/Ge/Ti/Ge). In the final Al-Ge-Ti ternary metal bond alloy the amount titanium can be for example 10 atomic percents still allowing a good mixing with Al and Ge over the eutectic temperature.

The benefit of adding titanium in the eutectic alloy is the formation of small solid compounds (AlGeTi, GeTi, AlTi) during eutectic solidification, suppressing the Al and Ge separation and finally resulting in less voiding. Further on, integrating a layer of Ti with aluminium the aluminium hillocks are reduced as well, improving the final eutectic bond quality.

Main difference between the first and second embodiment is in the cap layer 10. In the second embodiment, the cap layer 10 may be made of a plain monocrystalline silicon layer with dielectric-shielded vias 126. Dielectric-shielded vias 126 may comprise a doped monocrystalline or polycrystalline silicon rod within a dielectric tube 226, preferably formed of silicon dioxide, to electrically insulate them from the rest of the cap layer 10. Other parts of the cap layer 10 may be either plain or doped monocrystalline or polycrystalline silicon. The cap layer 10 is bonded to parts of the MEMS device layer 20 by a dielectric layer 127. This type of bonding is referred to as fusion bonding, also referred to as direct bonding. In this case, there are two direct bonds between silicon dioxide and silicon on both faces of the dielectric layer 127. Direct bonding, or fusion bonding, is a wafer bonding process without any additional intermediate layers. It is based on chemical bonds between two surfaces. In MEMS devises, typically manufactured using a silicon-on-insulator (SOI) process, the dielectric layer 127 is typically a silicon dioxide layer. Dielectric-shielded vias 126 extend through the silicon via patterns 115 of the cap layer 10 and the dielectric layer 127. As illustrated in the figure 2, there may be a dielectric outer layer 228 on the first face of the cap layer 10. In such case, the dielectric-shielded vias 126 further extend through the dielectric outer layer 228 to electrically attach the dielectric-shielded vias 126 all the way to metal pads 106 and solder bumps 110 on the bottom face of the MEMS device 500. The MEMS device layer 20 may comprise first through-silicon-vias 214 and/or second through-silicon-vias 215 according to the design. The figure 2 further illustrates a MEMS-test-TSV 129 that couples a signal from a second electrode 303 all the way to the first side of the cap layer 10. This kind of direct connections enable access to a MEMS signal from the outside of the MEMS device for example for testing and/or calibration purposes, if desired.

Figure 2 further shows a dielectric bump 133 applied on a second electrode 303 on the first face of the ASIC layer 30. Purpose of the dielectric bump 133 is to restrict out-of-plane movement of a movable element 25 in the MEMS device layer, and to prevent the movable element 25 to become in contact with the second electrode 303, which could cause for example sticking of the movable element 25 with the second electrode 303.

Figure 3 illustrates a cross-section of MEMS devices 500 according to a third embodiment. Figure 3 shows layers of two MEMS devices 500 on MEMS, ASIC and cap wafers before separating the MEMS devices 500 into individual devices. Between the individual MEMS devices 500, all three layers comprise a dicing street 308, which refers to a portion of the wafers that has no functional elements of the MEMS device 500 that is used for separating individual MEMS devices 500 from each other.

Although not specifically shown in connection with figures 1 and 2, manufacturing of MEMS devices 500 is preferably performed in wafer form, without separating individual devices by dicing, until the manufacturing process has been completed. Preferably, the manufacturing process also comprises testing of the MEMS devices before dicing.

Each MEMS device 500 has the same three layers 10, 20, 30 as in the first and second embodiment.

In the third embodiment, the cap layer 10 and parts of the MEMS device layer 20 are bonded to each other by metal bonding 327, and the ASIC layer 30 and parts of the MEMS device layer 20 are bonded to each other by metal bonding 327. Alternatively, eutectic bonding by Al-Ge or Cu-Ge alloy may be used. In case of two separate wafer level metal bonding methods are used, eutectic metal alloy of the latter bonding can be different, having lower eutectic melting point.

For example, if the first wafer bonding alloy is Al-Ge having eutectic melting temperature of 424°C the second wafer bonding alloy could be for example Gold-Silicon, Au-Si (363°C), Tin-Copper, Sn-Cu (227°C) or Tin-Silver (217°C).

Figure 3 illustrates dielectric bumps 133 on first electrodes 101 and a second electrode 303. Depending on design of the MEMS device, dielectric bumps 133 may be used on first electrodes 101 and/or on second electrodes 303.

Figure 3 further shows used of dielectric pattern 83 among the metal bonding 227 patterned between parts of the ASIC layer 30 and parts of the MEMS device layer 20. Thickness of metal or eutectic bonding layer may vary, which could cause variation in free room between movable elements 25 in the MEMS device layer 20 and second electrodes 303 on the first face of the ASIC layer 30. By having dielectric pattern 83 with predetermined thickness on the second face of the MEMS device layer 20 during the bonding process, distance between the second face of the MEMS device layer 20 and the first face of the ASIC layer 30 is maintained during and after the bonding process. Thickness of the dielectric pattern 83 may be determined by a buried oxide layer that is used as a mask for patterning the metal or germanium bonding material pattern as will be described later.

Figure 3 illustrates one AS-TSV 125 in each MEMS device 500. Vias 135 in the cap layer 10 couple first electrodes 101 towards the outside of the MEMS device 500. This kind of vias 135 may be used for example for testing purposes. Some metal pads 106 and solder bumps 110 on the first face of the cap layer 10 may be blind, i.e. not electrically coupled to any active elements within the MEMS device layer 20 or to the ASIC layer 30.

Instead of a via 135 in the cap layer 10, although not illustrated in the figure 3, at least one first electrode 101 may be alternatively or additionally coupled by a through-silicon-via though the MEMS device layer 20 and via metal bonding 227, 327 to a coupling element 301 on the first face of the ASIC layer 30 for coupling the signal to and/or from the first electrode 101 towards the ASIC active circuitry. Preferably, second electrodes 303 on the face of the ASIC layer 30 are applied only if two-way detection of position/movement of a movable element 25 is desired in vertical direction. For one-way detection of vertical movement/position, it is preferable to use first electrodes 101 on the face of the cap layer 10.

By the above-disclosed embodiments and various combinations thereof, several technical benefits are achieved.

The idea of stacking the ASIC layer, the MEMS device layer and the cap layer not only enables short interconnections by the through-silicon-vias but also removes need for separate package and assembly of the MEMS device to the package, since outer faces of these layers and applied bonding layers provide good protection for all active elements enclosed by the structure.

The stacked layers also enable streamlining manufacturing process of the MEMS device, since all steps can be performed in wafer level, all the way from manufacturing the layers to testing of MEMS devices after all layers of the MEMS device have been bonded to each other. Dicing, in other words separating individual MEMS devices from each other may be performed after the MEMS devices have been tested.

Electrical connection paths between MEMS device layer and ASIC are minimized, and electrical connection paths between the ASIC layer to underlying PCB are short and had low and stable stray capacitances. AC signals inside the MEMS device are typically high impedance and easily disturbed by stray capacitance. Shorter and more stable electrical connections facilitate better and stronger signals and improved error compensation, which enables reducing size of the MEMS device. MEMS device size can be reduced in comparison to structures that use internal bonding wires, and also in comparison to MEMS devices in which signals are carried through the ASIC layer, because a complex ASIC, in particular its ASIC active circuitry 311 typically requires more lateral area than functional elements in the MEMS device layer 20. Furthermore, through-silicon-vias can be created in the MEMS device layer 20 with the very same manufacturing steps that are used for patterning the movable elements of the MEMS device layer.

Some embodiments of the MEMS device structure enable two-side out-of-plane detection, and gap depths that enable movement of movable elements in the MEMS device layer can be set separately.

Out-of-plane detection, in other words detection of movement of movable elements from the plane defined by the MEMS device layer is typically challenging to implement in accurate manner. At least the first and the third embodiment enable two-way out-of-plane detection, when detection electrodes can be implemented both above and under the movable element. For example, in MEMS gyroscopes, quadrature compensation can be implemented more efficiently with two-side out-of-plane detection, which reduces complexity and cost of ASIC circuitry needed. Accelerometers with z-axis detection are known to be challenging; dual out-of-plane detection provides stronger detection signals and better compensation.

Gap depths, in other words distances between movable elements in the MEMS device layer and MEMS device layer-facing faces of the cap layer and/or the ASIC layer can be individually and separately determined. Gap depth may be increased by creating recessed areas on a silicon face of the cap layer, and thickness of applied bonding layers and optional dielectric patterns further facilitate determination of distance between different layers of the structure.

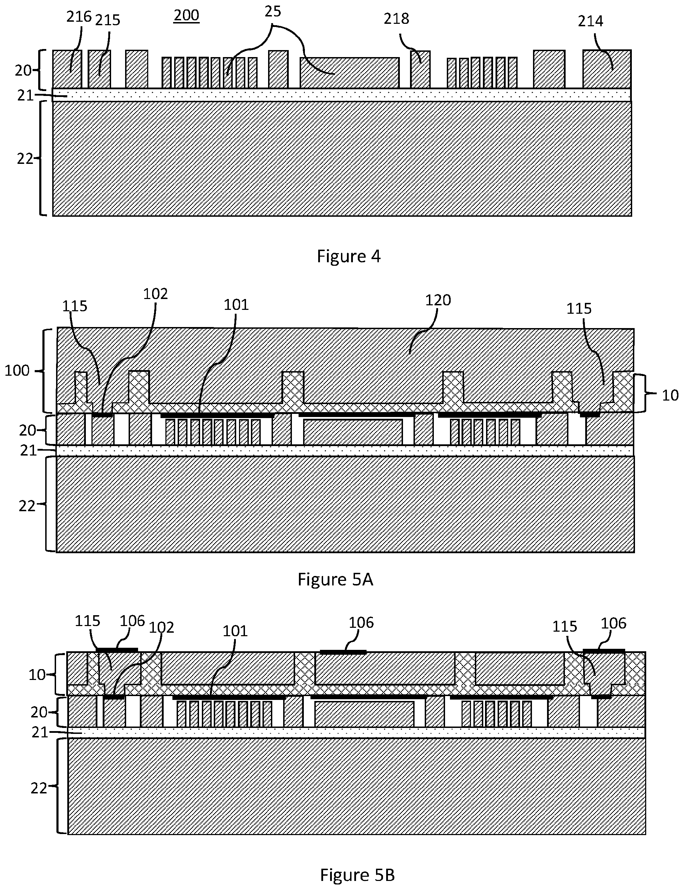

Figures 4 to 12 illustrate steps of an exemplary manufacturing method, which is typically performed in wafer form. Each wafer comprises elements of a plurality, typically thousands of MEMS devices. Wafers are stacked to form the desired layers of the MEMS devices, and the stack is diced only after the manufacturing process has been finalized. Preferably, MEMS devices are also tested and/or calibrated before dicing. Like in Figures 1 and 2, only a part of respective wafers corresponding to a single MEMS device is shown in Figures 4 to 13.

Figure 4 illustrates a portion of a MEMS device wafer 200 after the MEMS device layer 20 has been readily processed using known MEMS manufacturing processes. The exemplary MEMS device wafer 200 may be a so-called silicon-on-insulator, SOI, type, built on a Bonded SOI, BSOI, wafer using local oxidation of silicon, LOCOS, microfabrication process, and deep reactive ion etching, DRIE. The MEMS device wafer 200 comprises a substrate layer 22, a buried dielectric layer 21, and the MEMS device layer 20, which comprises movable elements 25 as well as through-silicon-vias 214, 215, 218. Typically, the buried dielectric layer 21 is silicon dioxide.

Figure 5A illustrates an optional phase in the manufacturing process, which is result of capping the MEMS device wafer 200 with a non-thinned cap wafer 100. In this context, the term non-thinned refers to a thickness of a layer or wafer that is greater than thickness of the respective layer in the finalized MEMS device. In other words, the non-thinned layer is to be thinned for example by grinding at a later point in the manufacturing process.

In this example, parts of the cap wafer 100 are anodic bonded on parts of the MEMS device layer 20. Before thinning, the cap wafer 100 comprises not only the cap layer 10, but also a non-patterned portion of the silicon wafer used for manufacturing the cap layer 10. It is also possible to thin the cap wafer 100 before it is bonded on the MEMS device wafer 200. Keeping the cap wafer 100 non-thinned during bonding may be beneficial, because the cap wafer 100 is mechanically robust in comparison to a thinner cap layer 10 desired in the final product. After thinning the cap wafer 100 into a desired thickness of the cap layer 10, the face of the cap layer 10 exposed by the thinning is provided with first electrodes 101, and it may also comprise metal patterns 102 to improve electrical contact between a part of the cap layer 10 and the respective part of the MEMS device layer 20. In this example, via patterns 115 of the cap layer 10 that will become parts of AS-TSVs are provided with metal patterns 102 on the second face of the cap layer 10.

Figure 5B illustrates a MEMS device layer 20 capped with a cap layer 10. This phase can be achieved either by bonding the cap layer 10 on parts of the MEMS device layer 20, or by bonding the cap layer 10 and thereafter thinning the cap wafer 100 illustrated in the figure 5A, removing the entire a non-patterned portion of the cap wafer 100, so that desired silicon areas, such as via patterns 115, are electrically separated from the rest of the silicon structures of the cap layer 10. Metal pads 106 are further added on the first face of the cap layer 10. Thinning cap wafer 100 may be implemented for example by grinding and etching. Grinding is a quick and cost-effective way of removing major portion of the cap wafer 100, but etching may be used to finalize the thinning.

If dielectric bumps (not shown), as shown in Figures 2 and 3, are desired on the first electrodes 101, those are added on the first electrodes 101 on the second face of the cap layer 10 at any suitable phase before it is bonded on the MEMS device layer 20.

The bonding between the MEMS device layer 20 and the cap layer 10, or the non-thinned cap wafer 100, may be implemented using any known CMOS-compatible low temperature wafer bonding method or CMOS non-compatible high temperature wafer bonding method. The applied bonding method may be selected among glass frit bonding, adhesive bonding, anodic bonding, eutectic metal bonding, metal to metal bonding and direct bonding, whereas the CMOS-compatibility of the selected method primarily depends on applied temperatures. In this context, low bonding temperature generally refers to bonding temperatures below 500°C. For example, the exemplary Al-Ge bonding of the ASIC layer 30 may be implemented using a bonding temperature that is slightly above 400°C. Thus, a bonding temperature between 400°C and 500°C can is considered low. Other applicable low temperature bonding methods are known in the art which may apply bonding temperatures below 200°C. A high bonding temperature refers to a temperature that exceeds temperatures tolerated by CMOS circuitry. A high bonding temperature may be above 500°C, and in some known bonding processes above 1000°C.

Table 1 below illustrates examples of known eutectic alloys used in MEMS bonding as well as eutectic temperatures thereof. For example, eutectic temperature for Al-Ge alloy discussed in the examples typically varies between 419 and 423 depending on composition. The actual temperature used for bonding may slightly exceed the eutectic temperature determined by the allow, as long as the higher temperature is compatible with characteristics of the respective bonded wafers. Thus, the temperature used for Al-Ge eutectic bonding may be up to 440°C, especially when the bond couples any other two layers but a CMOS ASIC layer.

**Table 1: Exemplary eutectic alloys commonly used in MEMS wafer-level packaging**

| **Eutectic alloy** | **Eutectic composition** | **Eutectic temperature** |
|---|---|---|
| **Al-Ge** | 49/51 wt% | 419°C |
| **Au-Ge** | 28/72 wt% | 361°C |
| **Au-In** | 0.6/99.4 wt% | 156°C |
| **Au-Si** | 97.1/2.9 wt% | 363°C |
| **Au-Sn** | 80/20 wt% | 280°C |
| **Cu-Sn** | 5/95 wt% | 231°C |

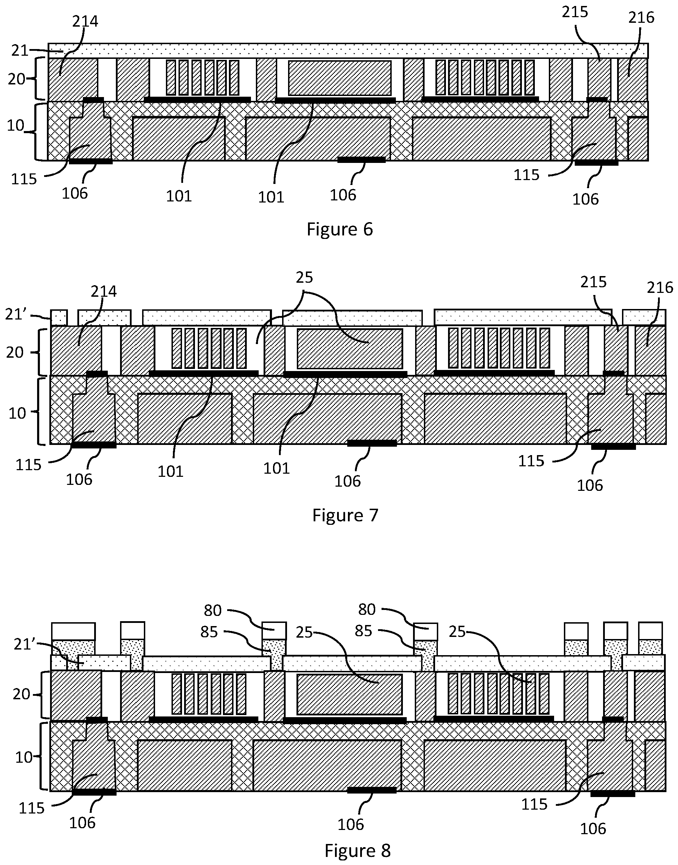

Figure 6 illustrates removal of substrate layer 22 from the MEMS device wafer 200, to release the buried dielectric layer 21. Substrate layer 22 may be removed by grinding, and etching may be used in final stage of substrate wafer removal to avoid mechanically harming the buried dielectric layer 21.

Since the buried dielectric layer 21 is typically thin, for example 1-3 µm and comprises of thermal silicon dioxide it obtains a compressive stress. In case the buried dielectric layer 21 spans over large distances of movable element 25 a dielectric stress compensation layer having tensile stress may be optionally added on top of the buried dielectric layer 21 at this stage. Such a tensile dielectric extra stress compensation layer could be silicon nitride (Si₃N₄, SixNy) or silicon oxynitride (SiOxNy) deposited for example by means of low temperature Plasma Enhanced Chemical Vapor Deposition (PECVD). Tension and also optical characteristics of the deposited silicon nitride or silicon oxynitride may be adjusted by adjusting flow of precursor gases, which results to an application-specific non-stoichiometric and structurally amorphic SixNy or SiOxNy film. By compensating the buried dielectric layer 21 stress, both processing robustness of the buried dielectric layer 21 and design freedom of movable element 25 in the MEMS device layer 20 is improved.

Figure 7 illustrates patterning of the buried dielectric layer 21, and the optional dielectric stress compensation layer (not shown) to form a dielectric mask 21'. As known in the art, the dielectric layer, such as the silicon dioxide layer, as well as the dielectric stress compensation layer, such as a silicon nitride or silicon oxynitride layer, can be patterned by etching. The etching process involves use of a photoresist layer (not shown), which defines the desired pattern.

Figure 8 illustrates deposition of bonding material using the dielectric mask 21'. In this example, the bonding material is germanium. Germanium may first be deposited over the entire area of the dielectric mask 21', and thereafter a photoresist mask 80 is added, which is then used for masking an etching process of the previously deposited germanium layer. As a result of depositing and patterning, there is germanium deposited in through holes in the dielectric mask 21' and germanium is also patterned on top of selected parts of the dielectric mask 21'.

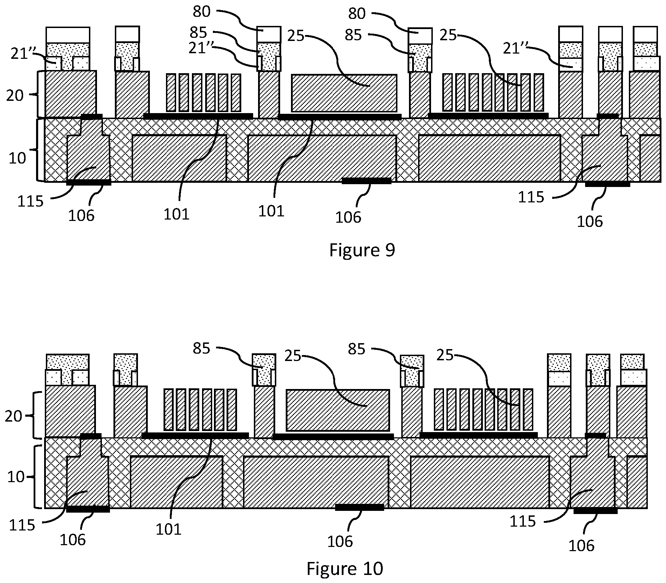

Figure 9 illustrates a phase after removal of the dielectric mask 21' by dry etching. The previously deposited bonding pattern 85 as well as the photoresist mask 80 remain in place at this phase, if the photoresist is such that it is not affected by the dry etching of the dielectric mask 21'. Because dry etching is directional, portions 21" of the dielectric mask remain in place, depending on design and used photoresist masks. One reason to keep portions 21" of the dielectric mask together with the bonding pattern 85 is to facilitate maintaining of a desired minimum distance between the first face or the to-be-bonded ASIC layer 30 and the second face of the MEMS device layer 20.

Figure 10 illustrates a phase after removal of the photoresist mask 80. The bonding pattern 85 remains as well as the portion 21" of the dielectric mask 21'.

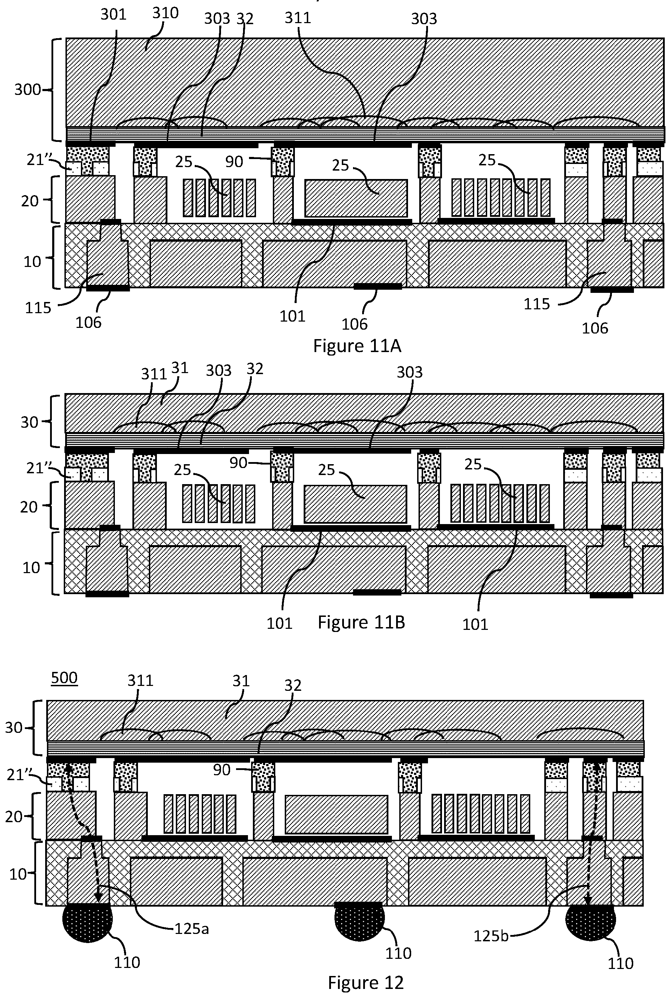

Figure 11A illustrates an optional step of bonding of a non-thinned ASIC layer 300 by eutectic bonding 90. The eutectic bonding is performed as known in the art. Bonding temperature, bonding duration and tool pressure are determined by the used materials. In this example, the non-thinned ASIC layer 300 is provided with a non-thinned substrate 310, and total thickness of the non-thinned ASIC layer 300 is more than desired thickness of the ASIC layer 30. This facilitates mechanical robustness of the non-thinned ASIC layer 300 during the manufacturing process. Metal for the eutectic bonding is provided as metallic patterns 301, 303 deposited on the first face of the non-thinned ASIC layer 300. These metallic patterns 301, 303 are preferably electrically coupled to ASIC active circuitry 311 within the ASIC layer 30. Metallic patterns 301, 303 are preferably made of one of Al, Au and Cu. As already explained above, the term non-thinned simply refers to a thickness of the respective layer (in manufacturing process, layer of the wafer) that is greater than thickness of the respective layer in the finalized MEMS device. In other words, the term non-thinned indicates that thinning of the respective layer is performed only after the non-thinned layer has been bonded in the desired position in the stack of layers for forming the MEMS device. Stacking and bonding of different layers of the MEMS device are preferably performed in wafer form for process economy reasons.

Figure 11B illustrates bonding of an ASIC layer 30 or thinning of the non-thinned ASIC layer 300. If the non-thinned ASIC layer 300 is bonded on the MEMS device layer 20 as illustrated in the figure 11A, the non-thinned substrate 310 may be thinned after bonding to arrive to the desired thickness of the ASIC layer 30. Thinning may be implemented for example by grinding. Thinning reduces volume of the MEMS device 500. Thinning of the non-thinned ASIC layer 300 only after bonding is beneficial because the thicker non-thinned ASIC layer 300 is mechanically more robust than a thinner ASIC layer 30 after the desired amount of substrate 310 has been removed by thinning. After bonding, the non-thinned ASIC layer 300 and thus also the ASIC layer 30 is supported by bonding on parts of the MEMS device layer 20.

When the ASIC circuitry is implemented using CMOS technology, the bonding between non-thinned ASIC layer 300 or the ASIC layer 30, and the MEMS device layer 20 may be performed using any CMOS-compatible low temperature wafer bonding method. The bonding method may be selected among glass frit bonding, adhesive bonding, anodic bonding, eutectic metal bonding, metal to metal bonding or direct bonding.

If dielectric bumps are desired on the second electrodes 303, these are manufactured on the portions of metallic patterns that will be used as second electrodes 303 prior to bonding the ASIC layer 30 or the non-thinned ASIC layer 300 on parts of the MEMS device layer 20.

Placement of electrodes for capacitive sensing of movement and/or position of movable elements 25 depends on type of MEMS device and design thereof. Depending on the design, electrodes may be arranged in the MEMS device layer 20 itself, on the face of the cap layer 10 facing the MEMS device layer 20, on the face of the ASIC layer 30 facing the MEMS device layer 20 and/or on any combination of these. In some embodiments, it may be desirable not to have any electrodes on the face of the ASIC layer 30 but only coupling elements 301 for conveying signals to and from the ASIC layer 30 and the ASIC active circuitry 311. For two-way capacitive detection of vertical, out-of-plane motion and/or position of a movable element 25, first and second electrodes 101, 303 are preferably placed on both the face of the cap layer 10 and on the face of the ASIC layer 30 that are towards the MEMS device layer 20. For one-way detection of out-of-plane motion and/or position of a movable element 25, only a single electrode is needed. In such case, the single electrode is preferably placed on the face of the cap layer 10 but may alternatively be on the face of the ASIC layer 30.

Figure 12 illustrates final steps of manufacturing the MEMS device 500 according to the first embodiment. Solder bumps 110 are added on metal pads 106. Signals from the ASIC active circuitry 311 are electrically coupled to the metal pads 106 and the solder bumps 110 by means of the first and/or second AS-TSVs 125a, 125b.

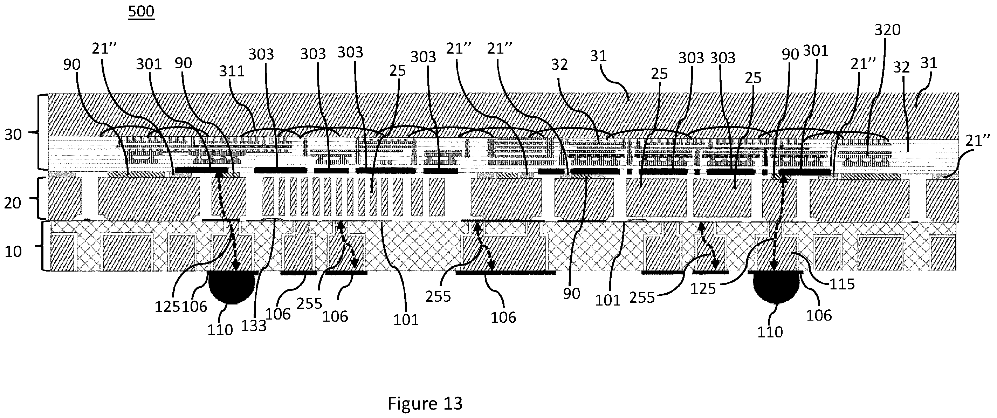

Figure 13 illustrates a cross-section of a MEMS device 500, illustrating some embodiments of the disclosure. This enlarged view of the MEMS device 500 illustrates a plurality of metal structures 320 in a multi-layered ASIC metal stack 32 not shown in detail in other Figures. Metal structures 320 of the ASIC metal stack 32 comprise at least electrical wiring (electrical connections) between ASIC active circuitry 311 and coupling elements 301. If there are second electrodes 303, the metal structures 320 may comprise electrical wiring (electrical connections) between ASIC active circuitry 311 second electrodes 303. Metal structures 320 may also comprise passive electrical components, such as resistors and/or capacitors.

In addition to AS-TSVs 125, there are also additional MEMS-test-TSVs 255, which provide an electrical connection from the MEMS device layer to respective metal pads 106 on outside of the MEMS device 500. These additional MEMS-test-TSVs 255 are useful for example for testing and/or calibrating the MEMS device. Testing and/or calibration is preferably performed on the plurality of MEMS devices while they have not been diced, in other words, are still in wafer form. This improves testing and/or calibration efficiency, while the plurality, possibly thousands of MEMS devices can be testes and/or calibrated even simultaneously, while probes of the test bed can be coupled to metal pads 106 electrically connected to the MEMS-test-TSVs 255. A MEMS-test-TSV 255 may, for example, provide a direct connection to a first electrode 101 arranged on the second face of the cap layer 10. A first electrode 101, which may be a static electrode, may be provided with a dielectric bump 133 to prevent sticking of a movable element 25 to the first electrode 101.

It should be noted that the above-discussed MEMS devices 500 are only illustrative examples, showing various structural alternatives that may be freely combined according to a design of an actual MEMS device 500, which may comprise for example one or more accelerometers and/or gyroscopes. Any suitable type of cap layer 10 can be used as long as capable of providing vias for electric signals and metal pads 106 for external connections for such electric signals. Various bonding methods are applicable between the ASIC layer 30 and parts of the MEMS device layer 20, and various bonding methods are applicable between the cap layer 10 and parts of the MEMS device layer 20, without limiting to any of the disclosed bonding method combinations discussed above. Drawings are not in scale. Some of the structures and/or layers have been exaggerated for clarity.

## Claims

1. A microelectromechanical (MEMS) device (500) comprising:
- an ASIC layer (30) comprising:
- an ASIC metal stack (32) towards a first face of the ASIC layer, wherein the first face of the ASIC layer (30) comprises a plurality of coupling elements (301) on the first face of the ASIC layer (30), wherein the plurality of coupling elements (301) is electrically coupled to the ASIC metal stack (32),
- a substrate (31) towards a second face of the ASIC layer, wherein face of the substrate layer that faces the ASIC metal stack (32) comprises ASIC active circuitry (311), and wherein the ASIC metal stack (32) is configured to convey signals between the ASIC active circuitry (311) and the plurality of coupling elements (301),
- a MEMS device layer (20) comprising functional elements of the MEMS device (500), wherein the MEMS device layer (20) has a first face and a second face, wherein parts of the second face of the MEMS device layer (20) are bonded on parts of the first face of the ASIC layer (30), and
- a cap layer (10) having a first face and a second face, wherein parts of the second face of the cap layer (10) are bonded on parts of the first face of the MEMS device layer (20) and the first face of the cap layer (10) is provided with a plurality of metal pads (106),
wherein the cap layer (10), the ASIC layer (30) and parts of the MEMS device layer (20) and optional bonding material between these layers form an enclosure for at least all movable functional elements of the MEMS device layer (20),
**characterized in that** mutually electrically connected parts of the MEMS device layer (20) and the cap layer (10) form at least one ASIC signal through-silicon-via, AS-TSV, (125) configured to electrically connect signals of the ASIC active circuitry (311) via some of the electrical contacts (301) on the first face of the ASIC metal stack (32) to the respective one of the metal pads (106) on the first face of the cap layer (10).

2. The MEMS device (500) according to claim 1, wherein said parts of the second face of the MEMS device layer (20) are CMOS-compatible low temperature wafer bonded on the first face of the ASIC layer (30), wherein the CMOS-compatible low temperature wafer bonding is selected among glass frit bonding, adhesive bonding, anodic bonding, eutectic metal bonding, metal to metal bonding and direct bonding.

3. The MEMS device (500) according to claim 1 or 2, wherein the parts of the second face of the cap layer (10) are CMOS-compatible low temperature wafer bonded, or CMOS non-compatible high temperature wafer bonded on parts of the first face of the MEMS device layer (20), wherein the CMOS-compatible low temperature wafer bonding and the CMOS non-compatible high temperature wafer bonded are selected among glass frit bonding, adhesive bonding, anodic bonding, eutectic metal bonding, metal to metal bonding and direct bonding.

4. The MEMS device (500) according to claim 1 or 2, wherein the parts of the second face of the cap layer (10) are bonded on parts of the first face of the MEMS device layer (20) by a dielectric layer (127), and wherein metal pads (106) are electrically coupled to parts of the MEMS device layer (20) by means of dielectric-shielded vias (126) extending through the dielectric layer (127).

5. The MEMS device (500) according to any one of claims 1 to 4, wherein the MEMS device layer (20) comprises at least one movable element (25) configured to be moveable in out-of-plane direction between the first face of the ASIC layer (30) and the second face of the cap layer (10), and wherein the MEMS device (500) comprises second electrodes (303) arranged on the first face of the ASIC layer (30) and/or first electrodes (101) arranged the second face of the cap layer (10) for capacitively detecting out-of-plane movement of the at least one movable element (25).

6. The MEMS device (500) according to claim 5, wherein at least one first electrode (101) and/or at least one second electrode (303) is provided with a dielectric bump (133) at the face of the respective at least one first electrode (101) and/or the at least one second electrode (303) facing the moving element.

7. The MEMS device (500) according to any one of claims 1 to 6, wherein at least one via portion (214) of the at least one AS-TSV (125) is disposed on the outer circumference of the MEMS device layer (20), thus forming part of outer walls of the enclosure.

8. The MEMS device (500) according to any one of claims 1 to 6, wherein the at least one AS-TSV (125) is coaxially shielded in the MEMS device layer (20) by a through hole or by a dielectric material surrounding respective via portion (215) of the MEMS device layer (20).

9. The MEMS device (500) according to any one of claims 1 to 8, wherein the cap layer (10) comprises sodium borosilicate glass and doped monocrystalline or polycrystalline silicon.

10. The MEMS device (500) according to any one of claims 1 to 8, wherein the cap layer (10) is a monocrystalline silicon layer comprising a plurality of dielectric-shielded vias (126).

11. The MEMS device (500) according to claim 10, wherein the dielectric-shielded via (126) comprises a doped monocrystalline or polycrystalline rod in a silicon dioxide tube.

12. The MEMS device (500) according to any one of claims 1 to 11, wherein, in addition to a metal bonding layer (227) or a eutectic bonding layer (217) between parts of the MEMS device layer (20) and the ASIC layer (30), dielectric patterns reside between parts of the MEMS device layer (20) and the ASIC layer (30), wherein the dielectric patterns are configured to provide further mechanical support and/or to facilitate maintaining desired distance between the first face of the ASIC layer (30) and parts of the second face of the MEMS device layer (20).

13. The MEMS device (500) according to any one of claims 1 to 12, wherein the plurality of metal pads (106) on the first face of the cap layer (10) are provided with solder bumps (110) for enabling soldering of the MEMS device (500) on a printed circuit board.

14. The MEMS device (500) according to any one of claims 1 to 13, wherein the MEMS device (500) is an accelerometer, a gyroscope or a combination thereof.
